# EUROPEAN PATENT APPLICATION

(11) **EP 2 669 689 A1**
(43) Date of publication of application: **04.12.2013**
(21) Application number: 12169797.3
(22) Date of filing: 29.05.2012
(51) Int. Cl.: G01R 29/08, H01Q 17/00, H05K 9/00

(54) **A chamber for testing electrical and electronic apparatus**

(71) Applicant: MBDA UK Limited, Stevenage, Hertfordshire SG1 2DA (GB)
(72) Inventor: The designation of the inventor has not yet been filed
(74) Representative: BAE SYSTEMS plc Group IP Department

(57) **Abstract**

A chamber (10) for EMC-testing electrical and electronic apparatus comprises a plurality of EM-field-reflecting ferromagnetic boundary sheets (40) connected to define an inner surface of the chamber (10) suitable for substantially containing an EM field. The chamber (10) also comprises a plurality of tiles (100), each tile (100) comprising an EM-field-absorbent material (110) and a magnetic backing material (150). The tiles (100) are detachably attached to the ferromagnetic boundary sheets (40) by the magnetic backing material (150). The plurality of tiles (100) are arranged to cover substantially the whole inner surface of the chamber (10). By attaching and removing the plurality of tiles (100) from the inner surface of the chamber (10), the chamber (10) can be converted from an EMC anechoic chamber to an EMC reverberation chamber (also known as a mode-stirred or mode-tuned chamber) and vice versa, respectively.

## Description

### FIELD OF THE INVENTION

This invention relates to the field of chambers in which electrical and electronic apparatus can be tested. The invention relates especially, although not exclusively, to chambers in which compliance with regulations regarding electromagnetic compatibility (EMC) can be tested.

### BACKGROUND ART

Some electrical and electronic devices can emit very high power electromagnetic (EM) fields. Such high-power fields can have a detrimental effect on other electrical and especially electronic equipment near to the emitting device (and indeed in some cases on such equipment far from it). Conversely, the electrical or electronic devices may themselves exhibit susceptibility to EM fields. This is especially a problem for electrical and electronic devices that are under development, as they can behave in an unforeseen manner, for example by emitting unexpected EM fields. In addition, some devices, for example some radar systems, are deliberately designed to produce very high power EM fields.

In order to simulate operation in an open, free-space environment whilst complying with EMC emissions regulations, devices that have the potential to emit high-power EM fields or have potential susceptibility to EM fields are typically tested in an anechoic chamber. An anechoic chamber is an enclosure, typically a room or box, large enough to contain the device being tested. It typically comprises a plurality of boundary sheets, typically aluminium or steel sheets, connected together to define an inner surface of the chamber for substantially containing an EM field. The chamber is designed to absorb substantially all generated EM radiation before it can leave the chamber, and is also designed so that reflections within the chamber are minimised. The inner surface of the chamber is carefully constructed to minimise gaps that might allow EM fields to leak out, whilst maintaining adequate ventilation for human access; air vents are carefully sized and shaped to allow air in and out but prevent EM fields from leaking out. Particular attention is paid to cabling that may have to enter the chamber to power and/or monitor the tested devices; metal cabling can potentially couple the energy associated with EM fields (e.g. as electrical currents) out of the chamber. The inner surface of the enclosure (including the ceiling and floor) is covered with a material that absorbs EM fields. Typically, the material is radar absorbent material (RAM). RAM comes in various forms, but in an anechoic chamber it is typically a fireproofed foam, e.g. a rubberised or urethane foam, loaded with carbon black or a mixture of carbon and iron particles. The foam is typically from a few cms to tens of cms thick (thicker foam provides more absorption) and is usually shaped to have a plurality of tapered protrusions, to provide impedance matching between the foam and air in the chamber, and hence reduce reflections at the interface between the two. The foam is typically manufactured (e.g. by Emerson & Cuming) in square tiles of side 600mm, and the tiles are glued over the walls and ceiling of the chamber, and simply rest on the floor (as gravity is sufficient to retain the tiles in place). Where the foam is thick, it is sometimes necessary to include thinner pieces, for example around the edges of the chamber, where sets of thicker tiles on adjacent walls project perpendicularly to each other and cannot both fit in the available space at the edge. A particular problem is that at least some kinds of foam-based RAM are susceptible to damage, and cumulatively disintegrate over time. A further problem is that the RAM is very bulky, taking up a great deal of space within the chamber, reducing the useable space available for other purposes.

Some anechoic chambers also include ferrite tiles, which again are glued to the walls and ceiling of the chamber and rest or are glued on its floor. These are tiles of ferrite material, which is ferromagnetic and relatively absorbent of lower-frequency EM fields (equivalently, more absorbent of magnetic fields) than is the aforementioned foam. These tiles are much thinner than the foam, typically a few hundred microns to a few mms in thickness. Because the ferrite is more resistive than iron/steel (equivalently, ferrous) metal, a lot of the energy in the electromagnetic waves is dissipated in its resistance as warming and there is much less reflection than would occur with ferrous (or other) metal walls.

Some anechoic chambers include both the ferrite tiles and the foam tiles, in order to provide increased absorption, absolutely and/or over a wider frequency range, without increasing the depth of RAM by very much. In these chambers, the foam is glued to the ferrite tiles, which form a base layer, which is, in turn, glued to the sidewalls and ceiling of the chamber and rests on or is glued to the floor.

Another form of chamber for testing EM devices is a reverberation chamber (also called a mode-stirred chamber or a mode-tuned chamber, depending on its mode of operation). Like an anechoic chamber, a reverberation chamber is designed to minimise leakage of EM radiation. However, unlike an anechoic chamber, a reverberation chamber is designed to maximise the intensity of EM fields within the chamber itself, and reflections from the inner surfaces of the chamber are therefore desirable. That typically necessitates careful construction; for example, weld joints are polished flat, to avoid potential absorptions from a rough joint (that can happen due to corona discharge, i.e. ionisation of the air, dissipating energy off rough spots that concentrate the electric field lines). These chambers are designed to maximise reflections of electromagnetic waves from their interior surfaces, firstly, in order to maximise the intensity of electromagnetic waves in the chambers for a given power specification of amplifier; secondly, in order to distribute and randomise the electromagnetic waves impinging upon the system under test in order to achieve a comprehensive range of exposures in terms of directionality and phase. Reverberation chambers typically include a rotating, reflective paddle, with multiple angled surfaces in a corner or at an edge of the chamber, which can be rotated to stir the electromagnetic standing waves in the chamber, consequentially varying the EM field vectors at each point in the chamber. (Mode-stirring corresponds to the case where the paddle is rotated continuously, whereas mode-tuning describes the situation when the paddle is rotated between system exposures, but is at rest during each test.) Reverberation chambers are typically used to test the behaviour of electronic devices when exposed to very high intensity EM radiation, usually over a broad band of wavelengths. A reverberation chamber typically comprises high-conductivity boundary sheets, typically steel sheets, connected to define a chamber having an inner surface suitable for substantially containing and reflecting an EM field. As with an anechoic chamber, the inner surface is carefully constructed to minimise gaps that might allow EM fields to leak out, whilst maintaining adequate ventilation for human access, and particular attention is paid to cabling. The high-power EM fields in a reverberation chamber also present a fire risk, necessitating the installation of fire detectors, sprinklers and/or other fire countermeasures.

Thus, the chambers must be carefully constructed, and anechoic chambers in particular require special materials in their construction. A consequence of that is that the chambers are typically very expensive to build, maintain and operate. Merely the RAM lining of a 100m³ anechoic chamber will at the present date typically cost £50,000 to £60,000. The build cost of the metal walls would double this figure and there would be added costs of installation, site preparation and the like. Finally, there is an overhead cost associated with housing and maintaining such a chamber that is of the order of £100,000 per annum.

It would be advantageous to provide a chamber for testing electrical devices that can be used more efficiently, and hence more cost-effectively, than chambers that are presently available.

### DISCLOSURE OF THE INVENTION

A first aspect of the invention provides a chamber for testing electrical and electronic apparatus, comprising: (i) a plurality of EM-field-reflecting ferromagnetic boundary sheets connected to define an inner surface of the chamber suitable for substantially containing an EM field; and (ii) a plurality of tiles, each tile comprising an EM-field-absorbent material (e.g. RAM) and a magnetic backing material, the tiles being detachably attached to the ferromagnetic boundary sheets by the magnetic attraction of the backing material, and the plurality of tiles being arranged to cover substantially the whole inner surface of the chamber; wherein, by attaching and removing the plurality of tiles from the inner surface of the chamber, the chamber can be converted from an EMC anechoic chamber to an EMC reverberation chamber and vice versa, respectively.

The term "reverberation chamber" is interchangeable with the term "mode-stirred chamber" and the term "mode-tuned chamber".

It may be that the tiles are attached to the ferromagnetic boundary sheets solely by the magnetic attraction of the magnetic backing material.

The inventor's experience is that prior-art anechoic and reverberation chambers stand idle for much of the much of the time in EMC test facilities, as there is sometimes a need for one and sometimes the other. As discussed above, the chambers are very expensive. The invention enables a reverberation chamber to be converted into an anechoic chamber, and vice versa, which in turn enables efficient use of the chambers, according to need. That can be expected to result in fewer chambers being required in an EMC test facility, providing significant cost savings. Also, a single bigger chamber can be provided where previously two chambers were required, both of which would therefore have had to be smaller.

The ferromagnetic boundary sheets may be high conductivity sheets, for example metallic sheets, for example, steel.

The boundary sheets may be connected to form a floor, walls, a roof, and a door of the chamber.

The boundary sheets may be connected together with smooth joints, for example smoothed (e.g. polished) weld joints.

Preferably, the inner surface has no sharp corners or edges (i.e. no corners or edges having a radius of curvature small enough to enable a corona discharge at the peak potential differences induced within the chamber). Preferably, the inner surface has no gaps bigger than an operating wavelength of the EM fields. It may be that relevant wavelengths are as short as 7.5mm, corresponding to an upper limit operating frequency of 40GHz. More preferably, any gaps in the inner surface are very much smaller than the operating wavelength of the EM fields.

For a given source amplifier the field inside the chamber rises to a level such that the total rate of loss of the stored electromagnetic energy equals the emission power of the amplifier (which may for example be in the range 1 kW to 10kW). It is desirable that the great majority of this energy loss should be converted to heat energy within the structure of the chamber. Seepage of energy to the environment of the chamber in the form of EM waves needs to be minimal (preferably <0.1 %), because EM radiation can be dangerous at such power levels.

It may be that the tiles are of a plurality of different shapes. It may be that the tiles are of a side of less than 1 m, less than 800 mm, less than 700 mm, less than 600 mm, less than 500 mm, or less than 400 mm. It may be that the tiles are of a side of greater than 100 mm, greater than 200 mm, greater than 400 mm, greater than 500 mm, greater than 600 mm, or greater than 700 mm.

It may be that the tiles are of an overall depth greater than 50 mm, greater than 60 mm, greater than 70 mm, greater than 80 mm, greater than 90 mm or greater than 100 mm. It may be that the tiles have an overall depth of less than 1000mm, less than 900 mm, less than 800 mm, less than 700 mm, less than 600 mm, or less than 500 mm.

It may be that the plurality of tiles comprises tiles that have an impedance matched profile, for example, they may include protrusions (for example pyramidal protrusions) that are tapered to a point or line. It may be that the plurality of tiles includes tiles that are flat, i.e. without protrusions or that include truncated protrusions; for example protrusions that are tapered to a flat surface. It may be that the flat tiles and/or the truncated tiles are arranged around the edges of the chamber when it is in an anechoic configuration.

It may be that the EM-absorbing material is urethane foam or a rubberised foam material. Preferably, the EM absorbing material is fire-proofed. It may be that the EM-absorbing material is loaded with carbon black, or carbon, iron, or a mixture thereof.

It may be that the magnetic backing material is a ferromagnetic material. It may be that the magnetic backing material has a high ability to absorb energy from low frequency EM waves. Similar magnetically loaded silicone rubber sheet is marketed as a high loss, low frequency absorber for EM cavities (e.g. Eccosorb MCS by Emerson & Cuming). Those properties are partly a function of the resistivity of these sheet materials being orders of magnitude higher than for metals; hence induced currents dissipate energy as heating in the material. It may be that the magnetic backing material is plain magnetic sheeting. It may be that the magnetic backing material has a thickness of more than 0.1 mm, for example more than 0.3 mm, for example more than 0.5 mm, for example more than 0.7 mm. It may be that the magnetic backing material has a thickness of less than 5 mm, for example less than 3 mm, for example less than 1 mm, for example less than 0.8 mm. It may be that the absorbing material is glued to the magnetic backing material.

It may be that the EM field is an RF field or a microwave field.

A second aspect of the invention provides a method of using an EMC anechoic chamber, the EMC anechoic chamber comprising a plurality of EM-field-reflecting ferromagnetic boundary sheets connected to define an inner surface of the chamber suitable for substantially containing an EM field and a plurality of tiles, each tile comprising an EM-field-absorbent material and a magnetic backing material, the tiles being detachably attached to the ferromagnetic boundary sheets by the magnetic attraction of the backing material, the plurality of tiles being arranged to cover substantially the whole inner surface of the EMC anechoic chamber, the method comprising converting the EMC anechoic chamber into an EMC reverberation chamber by removing the plurality of tiles from the inner surface of the chamber. For example, the removal of a tile may comprise the step of peeling from a corner of the tile to break the magnetic adhesion bond.

A third aspect of the invention provides a method of using an EMC reverberation chamber, the EMC-reverberation chamber comprising a plurality of EM-field-reflecting ferromagnetic boundary sheets connected to define an inner surface of the chamber suitable for substantially containing an EM field, the method comprising converting the EMC reverberation chamber into an EMC anechoic chamber by attaching to the inner surface of the chamber a plurality of tiles, each tile comprising an EM-field-absorbent material (e.g. pyramidal RAM) and a magnetic backing material, the tiles being detachably attached to the ferromagnetic boundary sheets by the magnetic attraction of the backing material, the plurality of tiles being arranged to cover substantially the whole inner surface of the EMC anechoic chamber.

It will of course be appreciated that features described in relation to one aspect of the present invention may be incorporated into other aspects of the present invention. For example, the methods of the second or third aspect of the invention may incorporate any of the features described with reference to the first aspect of the invention and *vice versa.*

### BRIEF DESCRIPTION OF THE DRAWINGS

Example embodiments of the invention will now be described by way of example only and with reference to the accompanying drawings, of which:
Figure 1 is a reverberation chamber before adaptation according to an example embodiment of the invention;
Figure 2 is a magnetic RAM tile for use in converting the chamber of Fig. 1 to an anechoic chamber;
Figure 3 is the reverberation chamber of Fig. 1 partially converted to an anechoic chamber;
Figure 4 is the chamber of Fig. 1 converted to an anechoic chamber;
Figure 5 is plots of the calibration curves (reduction in signal in dB versus frequency in MHz) for a chamber according to an example embodiment of the invention (these measurements are from the photographed chamber of Figs. 1
to 4) and for a bespoke large anechoic chamber of conventional design, for (a) the horizontal polarisation and (b) the vertical polarisation. The plots also include target curves and acceptable deviations therefrom, according to recognised EMC standards (this was the Normalised Site Attenuation (NSA) chamber calibration test: see DEF STAN 59-411 Part 3 Appendix 8: Screened Room Damping Performance Verification Procedure).

For convenience and economy, the same reference numerals are used in different figures to label identical or similar elements of the apparatus shown.

### DETAILED DESCRIPTION

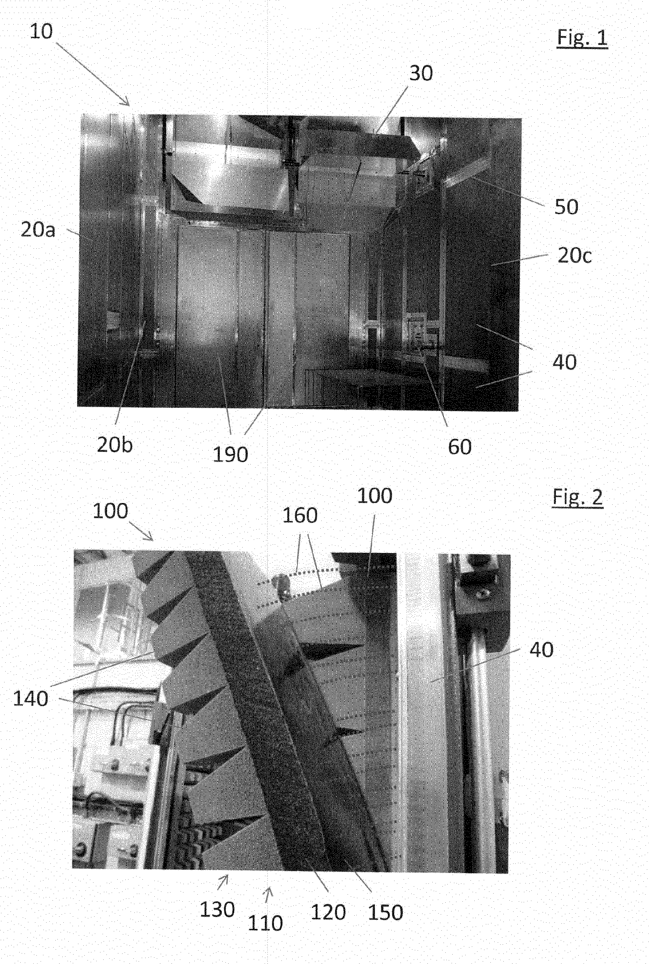

In an example embodiment of the invention, a chamber 10 is initially configured as a reverberation chamber (Fig. 1). The chamber 10 has walls 20a, 20b, 20c, 20d, floor 170 and ceiling 180, each of which is constructed from a plurality of steel panels 40. The panels 40 are welded together, and the weld lines 50 are ground flat and smooth. Wall 20b includes a pair of doors 190, also made from steel panels. Wall 20c includes an air vent 60, sized and configured with a specialist metallic grill to minimise leakage of EM radiation. In its reverberation configuration, the chamber 10, also includes a removable paddle 30.

The chamber 10 can be converted from the reverberation configuration shown in Fig. 1 to an anechoic configuration. To achieve that, the paddle 30 is removed and RAM tiles 100 are attached magnetically to the steel panels 40 of the walls 20a, 20b, 20c, 20d, and ceiling 180 (Fig. 2). The RAM tiles 100 each have a RAM layer 110, formed of foam loaded with carbon black, and a magnetic layer 150. The RAM layer 110 has a uniform portion 120, which is a cuboidal block of the foam, and an impedance-matching portion 130, which is in the form of a plurality of (un-truncated) square-based pyramids 140, which are sized and shaped to provide impedance matching between the uniform portion 120 and the air inside the chamber 10. In the example, the uniform portion 120 and the impedance-matching portion 130 are formed together, as a single block.

The magnetic layer 150 is made from a magnetic material (SupaMag 0.75mm thick Plain Magnetic Sheets, 600mm x 600mm) obtainable from Anchor Magnets Ltd. (Bankside Works, Darnall Road, Sheffield, S9 5AH, England, tel. 0114 2564401). This material has been found to contribute to the RAM performance by absorbing low- to medium-frequency EM fields (and this absorption performance may potentially be improved if required by using thicker gauge magnetic sheets), whilst the RAM layer 110 itself absorbs the electric field component across the medium to high frequency range, so this approach has proven doubly effective. The magnetic material exhibits a partial ability to imitate the absorption properties of the ferrite tiles used as a backup layer behind the RAM in some conventional designs for anechoic chambers for the specific purpose of low-frequency magnetically coupled absorption.

Fig. 2 shows schematically the alignment of the magnetic attraction 160 between the magnetic layer 150 and the steel panels 40, to indicate how the RAM tiles 100 are magnetically retained on the walls 20a, 20b, 20c, 20d, and ceiling 180 of the chamber 10.

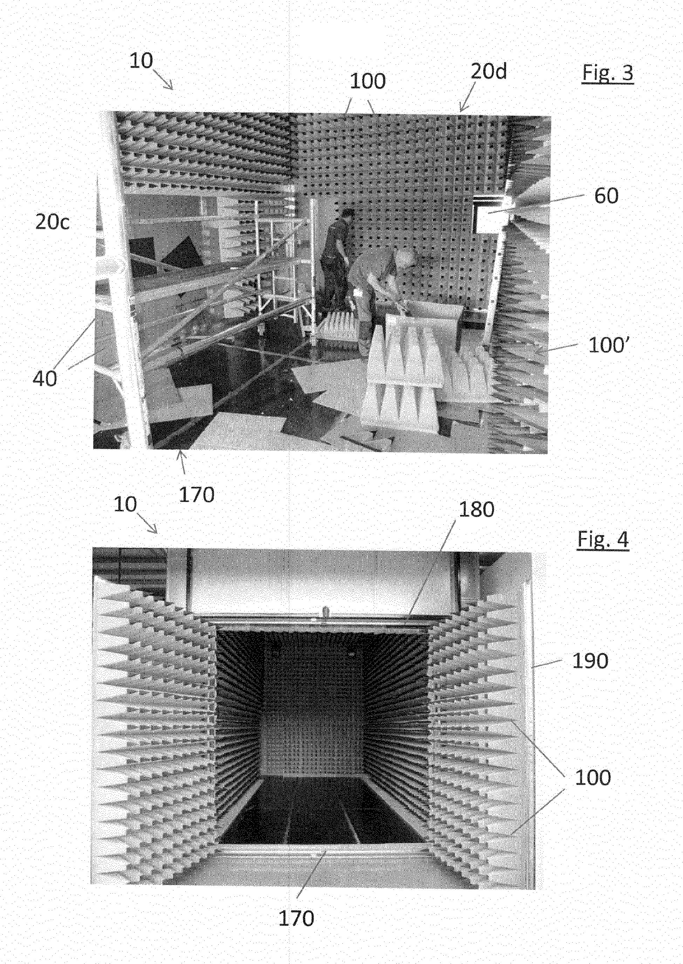

The RAM tiles 100 are tiled on the walls 20a, 20b, 20c, 20d, and ceiling 180 of the chamber 10 (Fig. 3). In some areas, different-shaped RAM tiles 100' are provided, which are thinner than the other RAM tiles 100, and have impedance-matching portions in the form of (possibly truncated) square-based pyramids. In other areas, still thinner RAM tiles are used, with no protrusions. (the adaptations to the geometry of the RAM tiles are to allow for the lining of doors, which need to be capable of being opened in use, and for fitting to corners and edges of the chamber, where the full-depth tiles would interfere with one another).

Finally, when the walls 20a, 20b, 20c, 20d, and ceiling 180 of the chamber 10 are completely covered (Fig. 4), the floor is tiled with RAM, in this example conventional RAM, without the magnetic layer 150 (though of course tiles 100 with the magnetic layer 150 could be used). The chamber 10 has then been fully converted for use as an anechoic chamber.

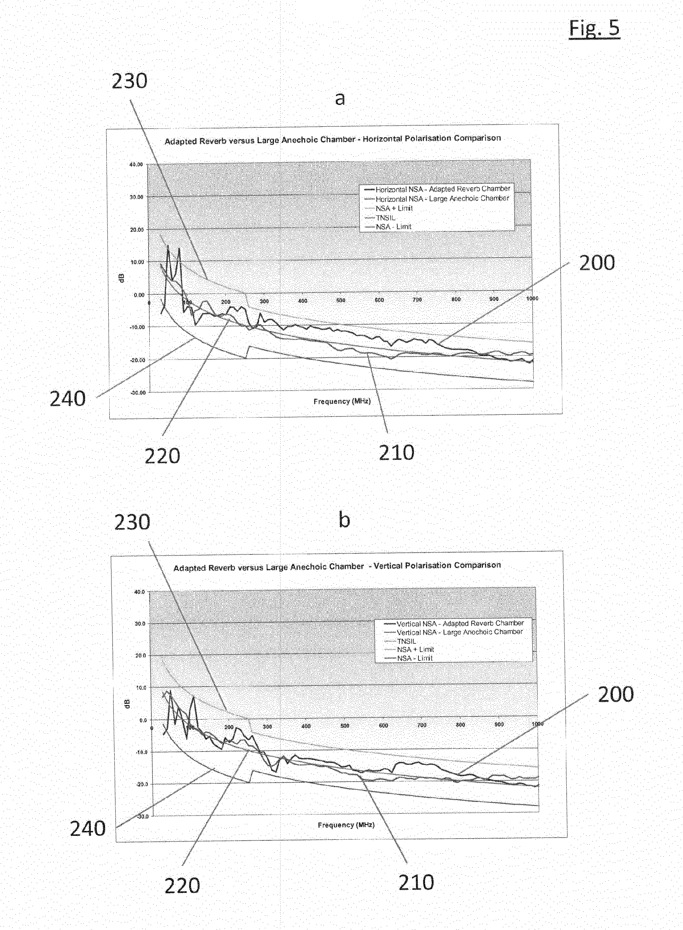

The performance of the chamber 10 in its anechoic form compares well with that of a conventional, purpose-built anechoic chamber. The plots of Fig. 5 show (line 200) the damping of the (a) horizontal and (b) vertical components as a function of frequency of an EM signal generated in the converted chamber 10. Also shown, for comparison, are the corresponding components in a conventional, purpose-built anechoic chamber (line 210), together with the Theoretical Normalised Site Insertion Loss (TNSIL) (line 220) and NSA + Limit (line 230) and NSA - Limit (these are the acceptance boundaries for the Normalised Site Attenuation calibration test as referenced above relative to the perfect behaviour specified by the TNSIL curves) (line 240). It will be seen that the converted chamber 10 provides a similar performance to the purpose-built chamber, and its performance is within the acceptable limits (lines 230, 240) over almost the whole frequency range. (There are a few spot frequencies at the lower end of the frequency range where the MagRAM chamber data slightly exceed the bounds, but these instances are few enough and mild enough to be easily addressed by small configuration tweaks, if required: use of thicker gauge magnetic sheeting would be a second approach to improving the low frequency end behaviour as required.)

This approach also has the incidental benefits of being very lightweight, so as not to strain the structure of the chamber 10 with an excessive mechanical load, and being of a nature that itself enhances the absorption of low-frequency components of the EM spectrum.

Thus, this approach facilitates extra adaptability and increased utilisation for existing reverberation chambers. It also provides a basic design principle for a new class of dual-mode EMC chambers, specifically designed to be operated interchangeably in either the anechoic or the reverberation configuration; such adaptable, dual-mode chambers have the potential to form the basis for a future class of smaller, more efficient, less capital intensive EMC test facilities in the future.

Whilst the present invention has been described and illustrated with reference to particular embodiments, it will be appreciated by those of ordinary skill in the art that the invention lends itself to many different variations not specifically illustrated herein.

Where in the foregoing description, integers or elements are mentioned which have known, obvious or foreseeable equivalents, then such equivalents are herein incorporated as if individually set forth. Reference should be made to the claims for determining the true scope of the present invention, which should be construed so as to encompass any such equivalents. It will also be appreciated by the reader that integers or features of the invention that are described as preferable, advantageous, convenient or the like are optional and do not limit the scope of the independent claims. Moreover, it is to be understood that such optional integers or features, whilst of possible benefit in some embodiments of the invention, may be absent in other embodiments.

## Claims

1. A chamber for testing electrical and electronic apparatus, comprising: (i) a plurality of EM-field-reflecting ferromagnetic boundary sheets connected to define an inner surface of the chamber suitable for substantially containing an EM field; and (ii) a plurality of tiles, each tile comprising an EM-field-absorbent material and a magnetic backing material, the tiles being detachably attached to the ferromagnetic boundary sheets by the magnetic attraction of the backing material, and the plurality of tiles being arranged to cover substantially the whole inner surface of the chamber; wherein, by attaching and removing the plurality of tiles from the inner surface of the chamber, the chamber can be converted from an EMC anechoic chamber to an EMC reverberation chamber and vice versa, respectively.

2. A chamber as claimed in claim 1, in which the boundary sheets are connected to form a floor, walls, a roof, and a door of the chamber.

3. A chamber as claimed in claim 1 or claim 2, in which the boundary sheets are connected together with smooth joints.

4. A chamber as claimed in any preceding claim, in which the inner surface has no gaps bigger than an operating wavelength of the EM fields.

5. A chamber as claimed in any preceding claim, in which the tiles are of a plurality of different shapes.

6. A chamber as claimed in any preceding claim, in which the tiles are of a side of greater than 100 mm and less than 1 m.

7. A chamber as claimed in any preceding claim, in which the tiles are of an overall depth greater than 50 mm and less than 1000 mm.

8. A chamber as claimed in any preceding claim, in which the plurality of tiles comprises tiles that have an impedance-matched profile.

9. A chamber as claimed in any preceding claim, in which the plurality of tiles includes tiles that are flat.

10. A chamber as claimed in any preceding claim, in which the EM-absorbing material is urethane foam or a rubberised foam material.

11. A chamber as claimed in any preceding claim, in which the EM-absorbing material is loaded with carbon black, or carbon, iron, or a mixture thereof.

12. A chamber as claimed in any preceding claim, in which the magnetic backing material is plain magnetic sheeting.

13. A chamber as claimed in any preceding claim, in which the EM field is an RF field or a microwave field.

14. A method of using an EMC anechoic chamber, the EMC anechoic chamber comprising a plurality of EM-field-reflecting ferromagnetic boundary sheets connected to define an inner surface of the chamber suitable for substantially containing an EM field and a plurality of tiles, each tile comprising an EM-field-absorbent material and a magnetic backing material, the tiles being detachably attached to the ferromagnetic boundary sheets by the magnetic attraction of the backing material, the plurality of tiles being arranged to cover substantially the whole inner surface of the EMC anechoic chamber, the method comprising converting the EMC anechoic chamber into an EMC reverberation chamber by removing the plurality of tiles from the inner surface of the chamber.

15. A method of using an EMC reverberation chamber, the EMC-reverberation chamber comprising a plurality of EM-field-reflecting ferromagnetic boundary sheets connected to define an inner surface of the chamber suitable for substantially containing an EM field, the method comprising converting the EMC reverberation chamber into an EMC anechoic chamber by attaching to the inner surface of the chamber a plurality of tiles, each tile comprising an EM-field-absorbent material and a magnetic backing material, the tiles being detachably attached to the ferromagnetic boundary sheets by the magnetic attraction of the backing material, the plurality of tiles being arranged to cover substantially the whole inner surface of the EMC anechoic chamber.
